# EUROPEAN PATENT APPLICATION

(11) **EP 4 641 263 A1**
(43) Date of publication of application: **29.10.2025**
(21) Application number: 24172363.4
(22) Date of filing: 25.04.2024
(51) Int. Cl.: G02B 1/113, G02B 1/118, C23C 16/27, G02B 1/14

(54) **A TRANSPARENT PROTECTIVE COVER FOR A DISPLAY DEVICE, AN ELECTRONICS APPARATUS, AND A METHOD THEREOF**

(71) Applicant: Mehta, Mitul, 2930 Brasschaat (BE)
(72) Inventor: Mehta, Mitul, 2930 Brasschaat (BE)
(74) Representative: Renaudo, Adrien Hanouar

(57) **Abstract**

A transparent protective cover (300) for a display device (400, 700, 902) is disclosed. The transparent protective cover (300) includes a discrete diamond layer (300-1). The discrete diamond layer (300-1) has at least one textured surface, diamond grain size below 500 nano meters, and dopants in the range of 10¹³ atoms/cubic centimeter to 10¹⁸ atoms/cubic centimeter. The display device (400, 700, 902) includes a stack of the transparent protective cover, a touch detection module, and a display module (404, 500, 600, 704). The display module (404, 500, 600, 704) is one of a liquid crystal display (LCD), an organic light emitting diode (OLED) display, active-matrix OLED (AMOLED) display, and quantum dot LED (QLED) display. The discrete diamond layer (300-1) protects the display module (404, 500, 600, 704), or the touch detection module form an external impact and provides optical efficiency, thermal dissipation, and antimicrobial properties to the display device (400, 700, 902) or an electronic apparatus configured with the display device (400, 700, 902).

## Description

### Technical Field

The present disclosure relates to a transparent protective cover for a display device. More particularly, the present disclosure relates to a discrete layer of diamond serving, at least in part, as a transparent protective cover for the display device, and also relates to a method for obtaining the transparent protective cover.

### Background

Display devices have revolutionized computing systems, such as mobile phones, smartphones, tablets, laptops, digital books, personal digital assistant, digital cameras, GPS devices, infotainment system for vehicles, and wearable devices (like smart watches, smart glasses, Augmented reality (AR) headsets, and Virtual reality (VR) headsets), touchscreens, medical/diagnostic devices, control panels, gaming consoles, along with presentation technologies, such as televisions and/or computer monitors. Display technologies like liquid crystal display (LCD), organic light-emitting diode (OLED), active-matrix organic light-emitting diode (AMOLED) display, or quantum dot LED (QLED) display have improved presentation and/or a viewing quality of such devices or apparatuses. Further, such displays have also improved portability of an associated electronic apparatus as they commonly possess relatively low weight and thickness.

Display devices generally form an important part of an electronic apparatus. A damage (e.g., a crack or a fracture) to a display device may render the electronic apparatus unusable and/or may cause further damage to an internal hardware of the electronic apparatus, e.g., by exposure of the internal hardware to an external environment. The construction of a display device is generally complex, as a display device may include a stack of multiple interactive and emissive layers, which may not be repairable once broken. Therefore, a damaged display device may only be replaced in an electronic apparatus, thus increasing maintenance costs associated with electronic apparatus.

US Patent No. 11,656,404 B2 relates to a transparent display which includes a transparent substrate and a patterned diamond layer formed on the transparent substrate to at least in part define a diamond waveguide. At least two electronic apparatus can be connected by the diamond waveguide, and can include a sensor, a transducer, or electronic circuitry, including communication, control, or data processing electronic circuitry.

US Patent Application Publication No. 2006/0017055 A1 relates to a display device with multiple diamond coatings deposited by a chemical vapor transport process at temperatures below 750° C. The display device includes a substrate as a base, an anode layer residing on the diamond substrate for emitting holes, a hole drift layer that includes a doped diamond coating residing on the anode layer, an emissive layer for emitting light and residing on the hole drift layer. The display device also includes an electron transport layer that includes a doped diamond coating residing on the light emitting layer, a cathode layer residing on the electron transport layer for emitting electrons that will drift towards the light emitting layer, and a diamond coated encapsulation layer for sealing the display device from atmospheric moisture.

US Patent No. 10,760,157 B2 relates to a transparent glass system that includes an optical grade silicon substrate, and a nanocrystalline diamond film on the silicon substrate. The diamond film is deposited using a chemical vapor deposition system having a reactor in which methane, hydrogen, and argon source gases are added. Further, US' 1 57 proposes a method of fabricating transparent glass that includes the steps of seeding an optical grade silicon substrate and forming a nanocrystalline diamond film on the silicon substrate using a chemical vapor deposition system having a reactor in which methane, hydrogen, and argon source gases are added.

US Patent Application Publication No. 2012/0164454 A1 relates to a diamond-like carbon (DLC) coated devices. A DLC-coated substrate includes a substrate and a H-doped DLC layer disposed on the substrate, where the DLC layer is doped with a Si material at least along an interface between the substrate and the DLC layer. The substrate may include a surface doped layer on the DLC layer opposite the substrate.

The documents US'404, US'055, US'157, and US'454, disclose the forming of a thin layer of diamond coating on a transparent substrate like glass. The glass or polyethylene-based protection layer suffers from optical losses at the glass-air interface or glass-thin film interface. The optical loss may impact display brightness, contrast, and may affect readability under sunlight. The coatings may have limited heat dissipation due to thin film nature and lack any contribution in improving optical properties of the display devices. Further, such thin coatings are prone to develop cracks or may peel over time.

### Summary

In one aspect, the present disclosure relates to a transparent protective cover for a display device. The transparent protective cover provides a protective cover over a display module or a touchscreen module of the display device. The transparent protective cover includes a discrete diamond layer comprising a first surface and a second surface. The second surface is configured to adhere to a display module of the display device and the first surface is configured to face away from the display module. At least one of the first surface and the second surface has a textured surface which is configured to direct light away from the display module in a predetermined direction. Further, the discrete diamond layer has a diamond grain size below 500 nano meters (nm), and dopants in the range of 10¹³ atoms/cubic centimeter to 10¹⁸ atoms/cubic centimeter.

The discrete diamond layer provides higher impact resistance, optical efficiency, thermal dissipation, and antimicrobial properties to the display device or the electronic apparatus, configured with such display device. Further, the discrete diamond layer is a monolithic structure produced by a chemical vapor deposition (CVD) process. Therefore, the one or more embodiments of the discrete diamond layers and the method to obtain the same, as described above, are eco-friendly as the discrete diamond layers are obtained without requiring deep excavations or mining. Further, the characteristics of the discrete diamond layers, as described above, makes them reusable.

In accordance with an example implementation, the textured surface includes plurality of protrusions which prevent internal reflection of the light back towards the display module. The plurality of protrusions are multi-faced structures and define at least one of a pyramidal structure, conical structure, moth-eye structure, or lens-shaped structure.

In another example implementation, a thickness of the discrete diamond layer is in the range of 0.1 milli meter (mm) to 0.3 mm. For example, the thickness of the discrete diamond layer may be 0.2 mm.

In an example implementation, the discrete diamond layer has nanocrystalline diamonds with grain size below 100 nm, and wherein grain boundaries of the nanocrystalline diamonds have sp2-bonded carbon atoms.

In yet another example implementation, a majority of diamond grains in the discrete diamond layer have sizes in the range of 200 nm to 300 nm.

In an example implementation, the discrete diamond layer is doped with one of a p-type boron and n-type phosphorus. Alternatively, the discrete diamond layer is doped with boron and nitrogen.

In another example implementation, the discrete diamond layer has crystal orientation of one of [111] lattice and [110] lattice.

In another aspect, the discrete diamond layer comprises a plurality of sub-layers. A doping concentration in each sub-layer of the plurality of sub-layers is different from doping concentration in an adjacent sub-layer of the plurality of sub-layers adjoining each sub-layer. Further, a doping element in each of the sub-layers is different from a doping element in the adjacent sub-layer, at least one layer of the plurality of sub-layers is undoped, and a diamond grain size in each sub-layer of the plurality of sub-layers is different from a diamond grain size in the adjacent sub-layer.

In yet another aspect, a display device includes a display module and the transparent protective cover. The display module is one of a liquid crystal display (LCD), an organic light emitting diode (OLED) display, an active-matrix OLED (AMOLED) display, and a quantum dot LED (QLED) display.

In yet another aspect, the display device includes a touch detection module to detect touch inputs received on the first surface of the discrete diamond layer. In one implementation, the touch detection module may be provided between the display module and the discrete diamond layer. In another implementation, the touch detection module has touch detection sensors provided at one of the first surface and the second surface of the discrete diamond layer. In yet another implementation, the touch detection module is integrated within the display module.

In an example implementation, an electronic apparatus includes the display device and a circuit board including at least one processor and a memory. The processor and the display device are coupled to each other through the circuit board.

In an example implementation, a method for obtaining a transparent protective cover for a display device through chemical vapor deposition (CVD) is described. The method includes providing a seed inside a CVD reactor, the seed being one of a silicon or a glass. The method includes exposing the seed to the chemical vapors for formation of the discrete diamond layer on the seed. Further, the method includes debonding the discrete diamond layer from the seed. The discrete diamond layer after debonding has a first surface and a second surface. The second surface is configured to adhere to a display module of the display device and the first surface is configured to face away from the display module. Thereafter, a textured surface is formed on at least one of the first surface and the second surface of the discrete diamond layer. The textured surface is configured to direct light away from the display module in a predetermined direction. A temperature and a pressure inside the CVD reactor are maintained at predetermined values and the chemical vapors are doped such that the obtained discrete diamond layer has dopants in the range of 10¹³ atoms/cubic centimeter to 10¹⁸ atoms/cubic centimeter. A diamond grain size in the obtained discrete diamond layer is below 500 nm.

In another example implementation, exposing the seed to the chemical vapors for formation of the discrete diamond layer includes forming multiple sub-layers by exposing the seed to a first type of chemical vapors for a first predetermined time period for formation of a first sub-layer over the seed and exposing the seed to a second type of chemical vapors for a second predetermined time period for formation of a second sub-layer over the first sub-layer. The first type of chemical vapors has at least one of a diamond grain size, a dopant element, and a doping concentration different from the second type of chemical vapors.

In an example implementation, the step of forming the textured surface on at least one surface of the discrete diamond layer includes forming the plurality of protrusions on at least one of the first surface and the second surface of the discrete diamond layer by one of photolithography, etching process, nanoimprint lithography, block copolymer lithography, and colloidal lithography.

Numerous advantages and benefits of the inventive subject matter disclosed herein will become apparent to those of ordinary skill in the art upon reading and understanding the present specification. It is to be understood, however, that the detailed description of the various embodiments and specific examples, while indicating preferred and/or other embodiments, are given by way of illustration and not limitation. Many changes and modifications within the scope of the present disclosure may be made without departing from the spirit thereof, and the disclosure includes all such modifications.

### Brief Description of the Drawings

FIG. 1A illustrates an embodiment of a display device of prior art;
FIG. 1B illustrates a display device of the prior art with touch detection module;
FIG. 2 illustrates a diamond coated protection layer of the prior art;
FIG. 3A illustrates a transparent protective cover for a display device, in accordance with some embodiments of the present disclosure;
FIG. 3B illustrates sub-layers of a discrete diamond layer of the transparent protective cover of FIG. 3A, in accordance with some embodiments of the present disclosure;
FIG. 3C illustrates an enlarged view of a portion of a surface of the transparent protective cover of FIG. 3A having protrusions that are defined by pyramidal structures, in accordance with some embodiments of the present disclosure;
FIG. 3D illustrates an enlarged view of a portion of a surface of the transparent protective cover of FIG. 3A having protrusions that are defined by moth-eye structures, in accordance with some embodiments of the present disclosure;
FIG. 3E illustrates an enlarged view of a portion of a surface of the transparent protective cover of FIG. 3A having protrusions that are defined by conical structures, in accordance with some embodiments of the present disclosure;
FIG. 3F illustrates an enlarged view of a portion of a surface of the transparent protective cover of FIG. 3A having protrusions that are defined by micro-lens structures, in accordance with some embodiments of the present disclosure;
FIG. 4 illustrates a display device with the transparent protective cover, in accordance with some embodiments of the present disclosure;
FIG. 5 illustrates the display device with a liquid crystal-based display module, in accordance with some embodiments of the present disclosure;
FIG. 6 illustrates the display device with an organic light emitting diode (OLED) based display module, in accordance with some embodiments of the present disclosure;
FIG. 7 illustrates a touchscreen device, in accordance with some embodiments of the present disclosure;
FIG. 8 illustrates a method for obtaining the transparent protective cover for the display device, in accordance with an embodiment of the present disclosure;
FIG. 9A is a perspective view of an electronic apparatus having the transparent protective cover integrated with a display device, in accordance with some embodiments of the present disclosure;
FIG. 9B is a schematic block diagram of the electronic apparatus of FIG. 9A, in accordance with some embodiments of the present disclosure;
FIG. 10 is a cross-sectional view of the electronic apparatus of FIG. 9A along a line 1-1 shown in FIG. 9A, in accordance with some embodiments of the present disclosure; and
FIG. 11 is a perspective view of a wearable device having the transparent protective cover integrated with a display device, in accordance with some embodiments of the present disclosure.

### Detailed Description

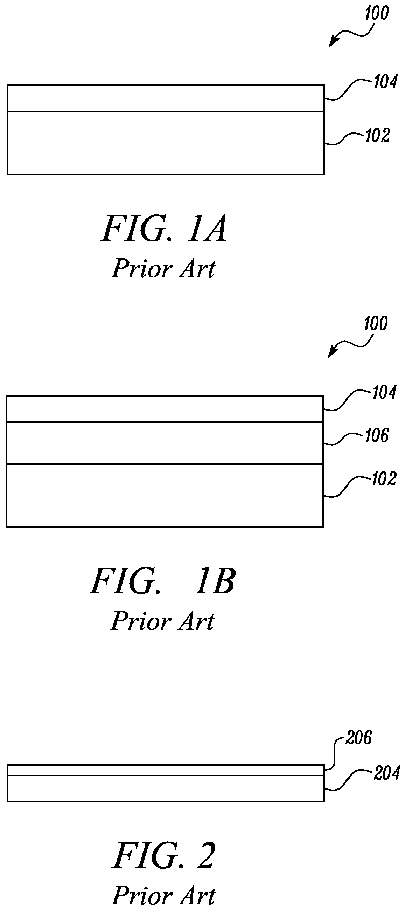

Referring to FIG. 1A, a display device 100 of the prior art is shown. The display device 100 includes a display module 102 and a protection layer 104. The protection layer 104 is typically made of glass or polyethylene. Referring to FIG. 1B, the display device 100 includes a touch detection module 106 usable by a user to touch and provide instructions to one or more processing units linked or associated with the display device 100. The touch detection module 106 is stacked or positioned between the display module 102 and the protection layer 104.

The protection layer 104 is made of glass or polyethylene. It will be acknowledged that glass or polyethylene is relatively fragile and prone to cracking or breaking or shattering upon an impact. This fragility limits the overall durability and lifespan of the display device 100 and/or an electronic apparatus employing the display device 100 and in which the protection layer 104 is applied. Further, the glass or polyethylene-based protection layers suffer from optical losses at the glass-air interface or glass-thin film interface. The optical loss may impact display brightness, contrast, and may affect readability and usability for a user/viewer of the display device 100, e.g., under sunlight. Such optical challenges may impact the overall viewing experience and may particularly limit outdoor visibility and usability, specially under bright light or sun light.

FIG. 2 illustrates a diamond coated protection layer 204 of the prior art. The protection layer 204 may be coated with a thin film 206 of diamond to improve the hardness of the protection layer 204. However, the coating is known to peel-off or decay with time.

The thin film diamond coatings of the prior arts are typically formed by directly depositing diamond grains onto a glass substrate of a display device using depositing techniques such as plasma-enhanced chemical vapor deposition (PECVD) or sputtering. A thickness of the deposited layer may range from a few nanometers to few micrometers, as known to those skilled in the art. However, the coatings have limited heat dissipation capacity and poor optical properties. Also, a life of the coating is dependent on the durability of an underlying glass/polypropylene layer. In some scenarios, the thin film coatings may be prone to delamination. Moreover, with the thin film coatings, obtaining multi-layered structures with varying properties is difficult and complex.

Further, existing solutions for protecting display devices merely focus on strengthening the durability of the protection layer. For example, a protection layer may include a chemically strengthened glass with anti-scratch and/or anti-reflective coatings or may include a tempered glass strengthened using heat. Similarly, covers coated with thin film of diamond rely solely on innate fundamental diamond material strengths. Effectively, the existing solutions are still limited in terms of impact resistance and optical efficiency.

Hereinafter, the preferred embodiments of the present disclosure will be described in conjunction with the accompanying drawings, it should be understood that the preferred embodiments described herein are only used to illustrate and explain the present disclosure and are not intended to limit the present disclosure. While several examples are described in the description, modifications, adaptations, and other implementations are possible. Accordingly, the following detailed description is not limited by the disclosed examples.

References to "some embodiment", "an embodiment", "at least one embodiment", "one example", "an example", "for example", "another example" and so on, indicate that the embodiment(s) or example(s) so described may include a particular feature, structure, characteristic, property, element, or limitation, but that not every embodiment or example necessarily includes that particular feature, structure, characteristic, property, element, or limitation. Furthermore, repeated use of the phrase "in some embodiment" does not necessarily refer to the same embodiment.

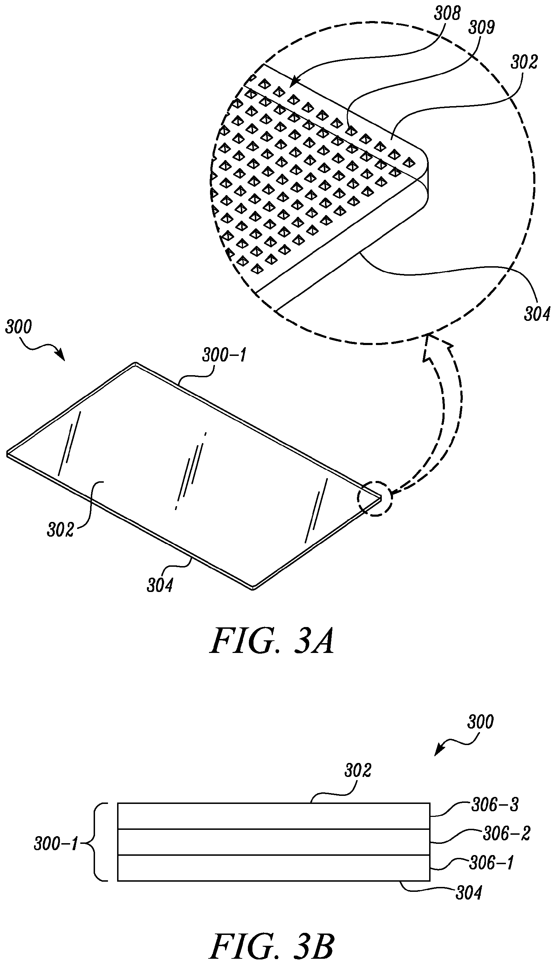

The present subject matter describes example transparent protective covers for display devices, example display devices with the transparent protective covers, example electronic apparatus with the transparent protective covers, and example methods of obtaining the transparent protective covers by synthesizing a discrete diamond layer. A display device may also be referred to as 'display panel' in the present description alternatively. A transparent protective cover of the present disclosure includes a discrete diamond layer. A display device of the present subject matter may include at least a display module and the transparent protective cover stacked or adhered over the display module such that the discrete diamond layer provides protection to the display module. The manner in which the transparent protective cover for the display device may be implemented is explained in detail with respect to FIG. 3A to FIG. 11.

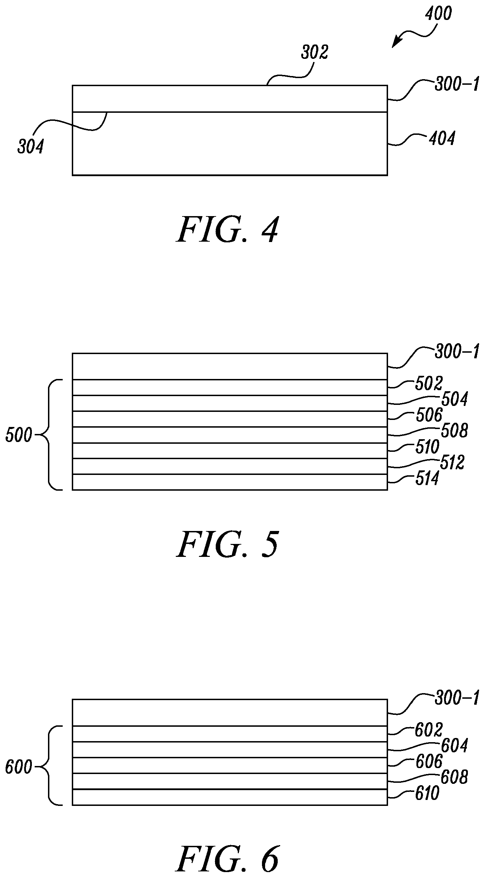

Referring to FIG. 3A, a transparent protective cover 300 for a display device (e.g., see display device 400 in FIG. 4) is shown and described. The transparent protective cover 300 provides enhanced impact resistance and improved optical characteristics to the display device 400. In this regard, the transparent protective cover 300 has a discrete diamond layer 300-1 with a first surface 302 and a second surface 304. The first surface 302 is disposed opposite to the second surface 304. Moreover, the second surface 304 is configured to adhere or attach to a display module (e.g., see display module 404) of the display device 400 and the first surface 302 is configured to face away from the display module 404.

In an example implementation, at least one of the first surface 302 and the second surface 304 has a textured surface 308. For example, referring to an enlarged view of a portion of the discrete diamond layer 300-1 in FIG. 3A, the first surface 302 has a textured surface 308. The textured surface 308 includes multiple protrusions 309 (for convenience and clarity only a single protrusion 309 is annotated in FIG. 3A) on the first surface 302.In some embodiments, the second surface 304 may be provided with a textured surface, such as the textured surface 308, as well, optionally or in addition to the textured surface 308 on the first surface 302. The protrusions 309 may directly interact with the light waves propagating from the display module 404 of the display device 400 and may direct light in a predetermined direction.

The predetermined direction may be a propagation path of a light emitted from the display module 404 (FIG. 4) of the display device 400 (FIG. 4) and which may be directed outside of the display module 404, with such a direction being exemplarily normal or perpendicular to a plane defined by the display device 400. In some embodiments, the predetermined direction may be defined to span across a field of view diverging out from the display device 400 to define the display device's viewing angle. The textured surface 308 prevents any internal reflection of the light back towards the display module 404. In some embodiments, the textured surface 308 may focus the light directed towards the viewer such that the viewing angle may be exemplarily confined within 140 to 150 degrees with respect to the display device 400. The values noted for the viewing angles are provided for illustrative purposes and may include other values. The protrusions 309 effectively function as optical elements, such as, microlens, which increase a light collection efficiency and help concentrate the light within the viewing angle. In an example implementation, the protrusions 309 may be multi-faced structures.

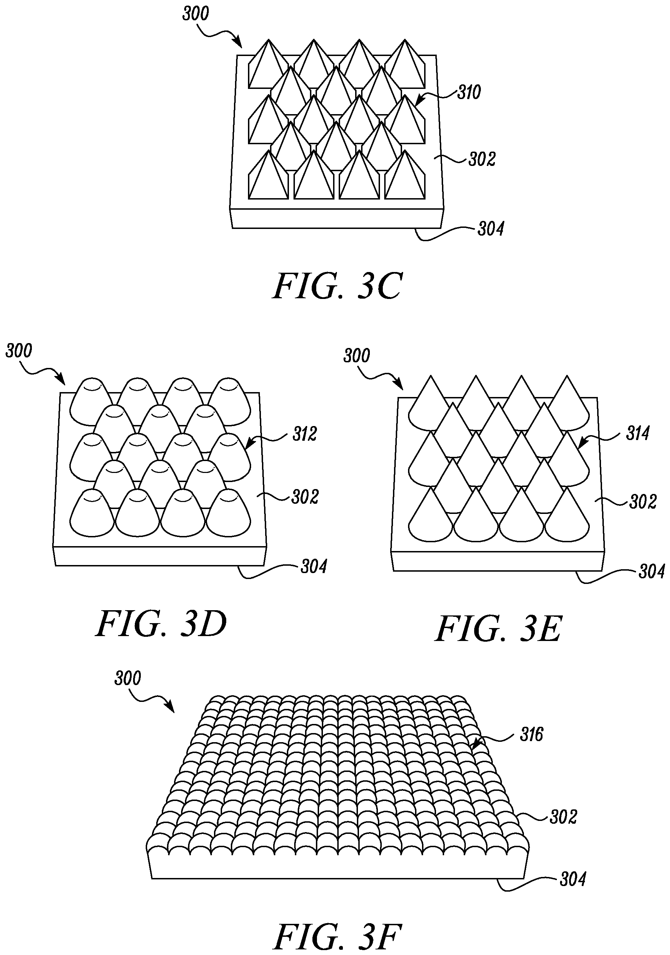

In an example implementation, FIG. 3C illustrates an enlarged view of a portion of the first surface 302 of the transparent protective cover 300 with the protrusions 309 defined as pyramidal structures 310. In an example implementation, FIG. 3D illustrates an enlarged view of a portion of the first surface 302 of the transparent protective cover 300 with the protrusions 309 defined as moth-eye structures 312. In an example implementation, FIG. 3E illustrates an enlarged view of a portion of the first surface 302 of the transparent protective cover 300 with the protrusions 309 defined as conical structures 314. In an example implementation, FIG. 3F illustrates an enlarged view of a portion of the first surface 302 of the transparent protective cover 300 with the protrusions 309 defined as micro-lens structure 316. The textured surface 308 on the first surface 302 (and/or on the second surface 304) may be provided by forming a lens-shaped structure, such as the micro-lens structure 316. Other structures of the protrusions 309, now known or in the future developed, may be contemplated by someone in the art. In some embodiments, the textured surface 308 may include one or more of the structures noted above.

In some embodiments, a thickness of the discrete diamond layer 300-1 may be in the range of 0.1 milli meter (mm) to 0.3 mm. More specifically, the thickness of the discrete diamond layer may be 0.2 mm. Other values may be contemplated, and the values provided for the thickness of the discrete diamond layer 300-1 are for illustrative purposes alone. In some embodiments, the discrete diamond layer 300-1 may have a controlled grain size distribution, where a diamond grain size in the discrete diamond layer 300-1 is below 500 nano meters (nm). In some embodiments, the majority (e.g., greater than 90%) of diamond grains in the discrete diamond layer 300-1 may have grain size distribution in a predetermined range of 200 nm to 300 nm, allowing a tuning of the refractive index of the discrete diamond layer 300-1 over visible bands.

In some embodiments, the discrete diamond layer 300-1 may be doped with of one a p-type boron and n-type phosphorus. The doping may range from 10¹³ atoms/cubic centimeter to 10¹⁸ atoms/cubic centimeter. In an example implementation, the discrete diamond layer 300-1 may be doped with boron and nitrogen. In some embodiments, the discrete diamond layer 300-1 may be synthesized to have a crystal orientation of (111) lattice or a crystal orientation of (110) lattice.

Referring to FIG. 3B sub-layers 306-1, 306-2, 306-3 of the discrete diamond layer 300-1 of the transparent protective cover 300 is illustrated and described. To this end, the discrete diamond layer 300-1 includes two or more sub-layers, e.g., three sub-layers 306-1, 306-2, 306-3, or in other words, a first sub-layer 306-1, a second sub-layer 306-2 and a third sub-layer 306-3, as shown. The first sub-layer 306-1 and the second sub-layer 306-2 are adjacent to (or adjoin) each other. Similarly, the second sub-layer 306-2 and the third sub-layer 306-3 are adjacent to (or adjoin) each other.

Each of the sub-layers 306-1, 306-2, 306-3 in the discrete diamond layer 300-1 may have different doping concentrations from an adjacent sub-layer 306-1, 306-2, 306-3 and/or may have a doping element different from a doping element present in the adjacent sub-layer 306-1, 306-2, 306-3 and/or may have a diamond grain size different from the diamond grain size of the adjacent sub-layer 306-1, 306-2, 306-3. For example, the second sub-layer 306-2 may have one of a doping concentration, a doping element or a diamond grain size different from a doping concentration, a doping element or a diamond grain size of first sub-layer 306-1 and the third sub-layer 306-3. For example, the first sub-layer 306-1 may have doping concentrations different from an adjacent sub-layer, e.g., the second sub-layer 306-2 and/or may have a doping element different from a doping element present in the second sub-layer 306-2 and/or may have a diamond grain size different from the diamond grain size of the second sub-layer 306-2. Similarly, the third sub-layer 306-3 may have a diamond grain size different from the diamond grain size of the second sub-layer 306-1. Various such examples may be contemplated by someone in the art.

Further, at least one sub-layer 306-1, 306-2, 306-3 may be undoped (e.g., may have a zero doping concentration), for example, the third sub-layer 306-3 may be undoped. In an example, at least one sub-layer 306-1, 306-2, 306-3 of the discrete diamond layer 300-1 may be undoped. For example, the third sub-layer 306-3 may be undoped and one or more of the first sub-layer 306-1 or the second sub-layer 306-2 may be doped (e.g., with boron). The sub-layers 306-1, 306-2, 306-3 of discrete diamond layer 300-1 may further have different configurations from one another and therefore, may exhibit different properties like enhanced optical performance or enhanced thermal dissipation characteristics. Furthermore, one or more of the sub-layers 306-1, 306-2, 306-3 may have the same thicknesses or may have different thicknesses.

In an example, the discrete diamond layer 300-1 may have any number of sub-layers with an overall thickness of the discrete diamond layer 300-1 falling within the predefined range of 0.1 mm to 0.3 mm. Therefore, the discrete diamond layer 300-1 having 3 sub-layers, i.e., sub-layers 306-1, 306-2, 306-3, is purely exemplary.

Referring to FIG. 4, the display device 400 with the transparent protective cover 300 has the discrete diamond layer 300-1 stacked over the display module 404, as noted above. Accordingly, the second surface 304 may be attached to the display module 404. In some embodiments, the display device 400 may be a touchscreen display where a touch detection module (e.g., see a touch detection module 702 provided for a touchscreen device 700 further below in the description) may be integrated with the discrete diamond layer 300-1. The touch detection module 702 may detect touch inputs provided at the first surface 302 of the discrete diamond layer 300-1. The touch input may be provided using a stylus or through a finger of a user (e.g., a human user). The discrete diamond layer 300-1 may have integrated touch sensors (not shown).

The touch sensors may be one or more of resistive, capacitive, infrared, or surface acoustic wave detectors. As diamond exhibits high input sensitivity, an input of the user is accurately detected by the touch detection module 702. In some embodiments, the touch sensors may be fabricated on the second surface 304 of the discrete diamond layer 300-1. The touch sensitivity of the discrete diamond layer 300-1 may be amplified or lessened or controlled by doping the discrete diamond layer with n-type phosphorus during a synthesis or production of the discrete diamond layer 300-1. In some embodiments, the display device 400 may have the touch detection module 702 integrated within the display module 404.

In an example implementation, the display module 404 may be based on Liquid Crystal Display technology and may accordingly be referred to as an LCD based display module 500, as shown in FIG. 5. To this end, FIG. 5 illustrates the display device 400 with the LCD based display module 500. With continued reference to FIG. 5, the display device 400 comprises the discrete diamond layer 300-1 stacked over the LCD based display module 500. The LCD based display module 500 includes a stack of layers having a first polarizer 502, a color filter 504, a layer of liquid crystal 506, a thin-film transistor (TFT) glass substrate 508, a second polarizer 510, and a backlight source having a diffuser plate 512 provided over an array of LEDs 514. In some embodiments, the LCD based display module 500 includes touch sensors integrated therein, and the same may be referred to as 'On-cell touch screens', and which may have the touch sensors provided below or under the first polarizer 502.

In another example implementation, the display module 404 may be based on organic light emitting diode (OLED) display technology or may be other variants of the OLED technologies, like Active-Matrix OLED (AMOLED) display technology or Passive-Matrix OLED (PMOLED) display technology.

In an example implementation, the display module 404 may be based on OLED display technology and accordingly referred to as an OLED based display module 600, as shown in FIG. 6. To this end, FIG. 6 illustrates the display device 400 with light emitting diodes (LEDs) based display module 600. The display device 400 of FIG. 6 includes the discrete diamond layer 300-1 stacked over the OLED based display module 600. The OLED based display module 600 includes a stack of layers having a polarizer 602, a layer of cathode electrode 604, a conducting layer 606 of emissive material(s), a layer of anode electrode 608 (or a TFT layer on organic substrate), and a substrate (610) which may be glass. Accordingly, the On-cell touch screens may have a capacitive layer, for touch detection, and such a capacitive layer may be provided between the polarizer 602 and the layer of cathode electrode 604.

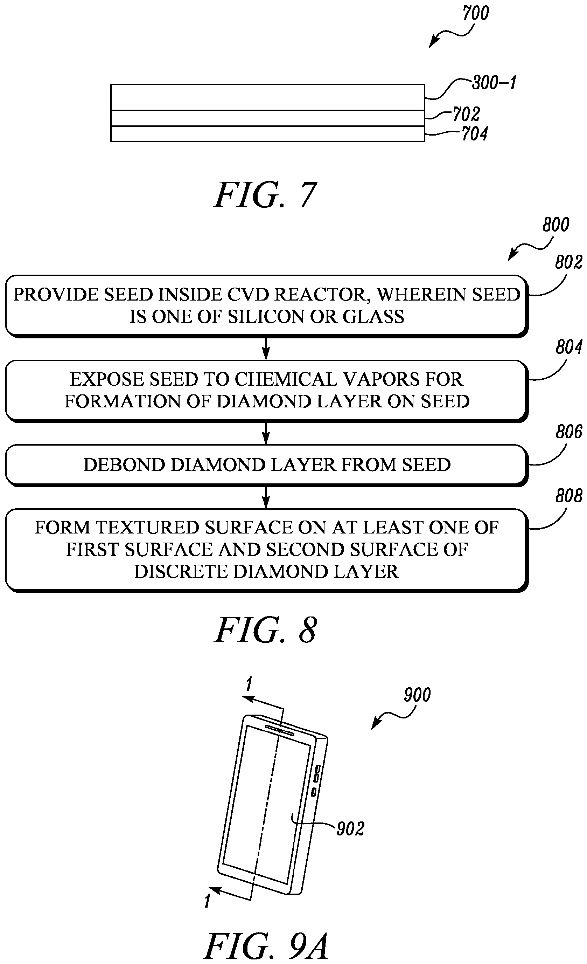

FIG. 7 illustrates a touchscreen device 700. The touchscreen device 700 may be a display device with an overlay touch panel/module. The touchscreen device 700 includes the discrete diamond layer 300-1 stacked over a touch detection module 702 and the touch detection module 702 is in turn stacked over a display module 704. In an example, the display module 704 may be the LCD based display module 500 or may be the OLED based display module 600 described above.

Generally referring to Figs. 3A to 7, it may be noted that the discrete diamond layer 300-1 provides a protective layer (e.g., as the transparent protective cover 300) over the touch detection module (e.g., the touch detection module 702) and/or over the display module (e.g., the display module 404, 500, 600, 704) for protecting the two from impacts, etc., when the discrete diamond layer 300-1 may be adhered or attached thereto. The discrete diamond layer 300-1 or the transparent protective cover 300 may be attached/adhered to the touch detection module 702 of FIG. 7 or to the display modules 404, 500, 600 through adhesive or through other techniques already known in the art.

The discrete diamond layer 300-1 may have the diamond grains oriented in a predetermined lattice. In an example, the discrete diamond layer 300-1 may have grains deposited heteroepitaxial on a silicon substrate which yields (111) lattice, i.e., trigonal oriented crystals. The discrete diamond layer 300-1 with (111) lattice provides enriched optical properties along a trigonal axis. According to another example implementation, the discrete diamond layer 300-1 may have grains oriented in accordance with (110) lattice. The crystal orientation in (110) lattice optimizes lateral thermal conduction spreading heat horizontally across the display device.

Referring back to FIG. 3A, the discrete diamond layer 300-1 may have the protrusions 309 formed throughout the first surface 302 and/or the second surface 304. The protrusions 309 may function as micro-lenses and therefore, may steer luminance from the display module (e.g., the display module 404, 500, 600, 704) in the predetermined direction and optimize brightness. The protrusions 309 may be formed by lithography and diamond plasma etching which can selectively create discrete optical protrusions on the first surface 302 or the second surface 304 of the discrete diamond layer 300-1.

Referring back to FIGS. 3C to 3F, the construction of the protrusions 309 on the first surface 302 or the second surface 304 of the discrete diamond layer 300-1 may result into the textured surface 308 with micro-scale or nano-scale features that restricts the light emitted from the display module (e.g., the display module 404, 500, 600, 704) within the predefined viewing angle of the display device (e.g., display device 400, 700). Further, the textured surface 308 reduces the refractive index between the discrete diamond layer 300-1 and air interface and which prevents an internal reflection within the display device (e.g., display device 400, 700). Therefore, with reduced the refractive index at diamond-air interface, the textured surface 308 serves two primary functions: (1) enhancing light extraction from the display module 404, 500, 600, 704 and (2) reducing glare and reflections for improved visibility.

In an example implementation, referring to FIG. 3C and FIG. 3E, the pyramidal or conical structures 310, 314 may have angled facets (as shown in FIGS. 3C and 3E) that direct maximum amount of light from the display module 404, 500, 600, 704 towards the viewer (e.g., a direction being generally perpendicular to a plane of the display module 404, 500, 600, 704) and prevent any internal reflection back towards the display module 404, 500, 600, 704, thereby increasing the light extraction efficiency from the display modules 404, 500, 600, 704. Although not limited, the pyramidal or conical structures 310, 314 may have base widths ranging from 100 nm to 5 nm and heights ranging from 100 nm to 3 nm.

In an example implementation, referring to FIG. 3D, the nanoscale moth-eye structures 312, alternatively referred to as bumps, are arranged in a pattern that resembles the surface of a moth's eye. The moth-eye structures 312 may reduce the refractive index at the diamond-air interface, with air being the fluid medium that may surround the display device 400, 700 and through which a user may view the display device 400, 700. The reduced refractive index reduces Fresnel reflections and glare. Although not limited, the moth-eye structures 312 may have diameters ranging from 50 nm to 500 nm and heights ranging from 100 nm to 1 nm, with a spacing between the structures of 50 nm to 1 nm.

In another example implementation, referring to FIG. 3F, the micro-lens structure 316 may be arranged in a random or periodic pattern on the first surface 302 and/or the second surface 304 of the discrete diamond layer 300-1. The micro-lens structure 316 diffuse and scatter the light from the display module 404, 500, 600, 704. The micro-lens structure 316 improve the viewing angle and reduce specular reflections. The micro-lenses may have diameters ranging from 1 nm to 50 nm and heights ranging from 500 nm to 10 nm, with a spacing between the lenses of 1 nm to 100 nm.

The textured surface 308 and/or the protrusions 309 including those that are indicated as 310, 312, 314, 316, of the discrete diamond layer 300-1 interact with light from the display module 404, 500, 600, 704 in several ways: 1) Enhanced light extraction: The micro-scale or nano-scale features reduce total internal reflection at the diamond-air interface by providing angled surfaces. Further, changes in gradual refractive index allow maximum amount of light to escape from the display module 404, 500, 600, 704 and which is directed towards the viewer. 2) Reduced glare and reflections: The textured surface 308 minimizes Fresnel reflections at the diamond-air interface by gradually changing the refractive index (with the moth-eye structures 312) or by scattering incident light (with array of the micro-lens structure 316), thereby reducing glare, and improving the display's visibility in bright environments. 3) Improved viewing angle: The array of the micro-lens structure 316 or the pyramidal structures 310 on the textured surface 308 diffuse and scatter light from the display module 404, 500, 600, 704, which increases the viewing angle and reduces the dependence on the viewing position. The textured surface 308 of the discrete diamond layer 300-1 provides comfortable viewing experience for a user.

In some embodiments, the discrete diamond layer 300-1 may function as a part of the touch detection module 702. In an example implementation, the second surface 304 of the discrete diamond layer 300-1 may have a layer of a transparent conductive oxide, such as indium tin oxide or aluminum-doped zinc oxide. The transparent conductive oxide may function as an electrode for the touch detection module 702. The second surface 304 faces the display module 404, 500, 600, 704. The transparent conductive oxide forms part of the touch detection module 702. In some embodiments, the second surface 304 may have a layer of a transparent conductive material, such as graphene or silver nanowires. The transparent conductive material may function as an electrode for the touch detection module 702. The transparent conductive material forms part of the touch detection module 702.

The discrete diamond layer 300-1 may be adapted for different sizes for application in various display devices. The discrete diamond layer 300-1 carries innate quality of a diamond. Further, the presence of dopants, orientation of crystals in specific lattice, and the protrusions 309 enhances thermal and optical characteristics of the discrete diamond layer 300-1. As a result, the discrete diamond layer 300-1 has an optical index which may be perpendicular to a plane of a substrate (not shown in Figures) of the display module 404, 500, 600, 704. The optical alignment of the discrete diamond layer 300-1 optimizes optical impedance matching and optical index matching, which prevents losses as light passes through the discrete diamond layer 300-1. Such optical impedance matching is unattainable with natural diamond. Thus, the discrete diamond layer 300-1 provides multifunctional capabilities by providing higher impact resistance as compared to a glass-based covers, optical efficiency, thermal diffusion, and antimicrobial properties, simultaneously.

In an example implementation, the display device 400, 700 may be configured with a flexible substrate to exhibit bending characteristics. Accordingly, the discrete diamond layer 300-1 may also exhibit flexibility to conform to the bending characteristics of the display device 400, 700. In another example implementation, the discrete diamond layer 300-1 may be foldable and accordingly the discrete diamond layer 300-1 may be utilized for foldable display devices.

In some embodiments, an interface between the discrete diamond layer 300-1 and the flexible substrate of the display module 404, 500, 600, 704 may include buffer layers for adhesion and stress dissipation. The buffer layers may be a nanocrystalline diamond transition layers or carbon-based adhesion layers, which mitigate stress concentrations and prevent delamination during flexing or folding.

Referring to FIG. 8, an exemplary method 800 to obtain or manufacture the transparent protective cover 300 for the display device 400, 700 is described by way of a flowchart. The method 800 includes the use of chemical vapor deposition (CVD) reactor as will be discussed below - although other techniques such as additive manufacturing may also be used in some cases.

The method 800 includes a CVD process. In the CVD process, a mixture of gases, methane and hydrogen, is introduced inside a reactor (e.g., a CVD reactor). Referring to FIG. 8, at step 802, a seed is provided and/or placed inside the CVD reactor. The seed may be a silicon-based substrate or a glass-based substrate. The seed may provide a specific growth condition and may control the diamond layer properties. For example, a silicon substrate yields (111) oriented crystal layers of a diamond.

At step 804, the seed is exposed to the chemical vapors for formation of the discrete diamond layer 300-1 on the seed. To obtain a diamond layer of specific characteristics, the environment inside the CVD reactor is maintained by adjusting the temperature and pressure at predetermined values, respectively. For example, the temperature may be maintained within the range of 500 degree Celsius to 1500 degree Celsius and the pressure may be maintained within the range of 10 Torr to 200 Torr. Further, the gases introduced inside the CVD reactor are doped such that the obtained discrete diamond layer 300-1 has dopants in the range of 10¹³ atoms/cubic centimeter to 10¹⁸ atoms/cubic centimeter and the diamond grain size is controlled in the range below 500 nm, more specifically within the range of 200 nm to 300 nm. The dopant may be a boron, nitrogen, or phosphorus. Also, the dopant may be a p-type boron or an n-type phosphorus.

The seed may be exposed to different types of chemical vapors with different concentration of dopants or different type of dopant elements or with different carbon-to-hydrogen ratios in the gas mixture resulting in different grain sizes. Further, the different sub-layers may be formed by exposing the seed to chemical vapors for a predetermined time period and the predetermined time period may be different for formation of each of the sub-layers. Accordingly, the step 804 may further include the steps of exposing the seed to a first type of chemical vapors for a first predetermined time period (t1) for formation of the first sub-layer 306-1 over the seed. Thereafter, exposing the seed to a second type of chemical vapors for a second predetermined time period (t2) for formation of the second sub-layer 306-2 over the first sub-layer 306-1. After that, exposing the seed to a third type of chemical vapors for a third predetermined time period (t3) for formation of the third sub-layer 306-3 over the second sub-layer 306-2. The first type of chemical vapors, the second type of chemical vapors, and the third type of chemical vapors may differ from one another based on at least one of a diamond grain size, a dopant element, and a doping concentration.

At step 806, the discrete diamond layer 300-1 formed over the seed is separated from the seed. The separation may be done by debonding the discrete diamond layer 300-1 from the seed. The debonding may be a chemical debonding. Alternatively, the separation may be performed using polymeric tape. Additionally, any excess or undesired growth of diamond on the discrete diamond layer 300-1 may be removed using known techniques such as laser cutting or etching process.

At step 808, the textured surface 308 may be formed on at least one of the first surface 302 or the second surface 304 of the discrete diamond layer 300-1. A process of forming the textured surface 308 may include forming the protrusions 309 on at least one of the first surface 302 and the second surface 304 of the discrete diamond layer 300-1. In one embodiment, the protrusions 309 on at least one of the first surface 302 and the second surface 304 of the discrete diamond layer 300-1 may be formed by an etching process. Thereafter, the discrete diamond layer 300-1 may be attached to the display module 404, 500, 600, 704 or to the touch detection module 702 using adhesive(s) or traditionally known methods.

The texture surface 308 may be fabricated using photolithography and etching. In photolithography and etching, a photoresist mask is patterned on a surface (e.g., one or more of the first surface 302 and the second surface 304) of the discrete diamond layer 300-1 using photolithography, and the exposed diamond is etched using techniques such as reactive ion etching (RIE) or inductively coupled plasma (ICP) etching to create the desired micro- or nano-scale features.

Optionally, the textured surface 308 may be fabricated using nanoimprint lithography. In nanoimprint lithography, a pre-patterned mold is pressed onto a surface (e.g., one or more of the first surface 302 and the second surface 304) of the discrete diamond layer 300-1, transferring the micro- or nano-scale features onto the discrete diamond layer 300-1. The discrete diamond layer 300-1 is then etched using reactive-ion etching (RIE) or inductively coupled plasma (ICP) etching to remove the residual diamond and reveal the textured surface 308.

As another option, the textured surface 308 may be fabricated using self-assembly techniques. In self-assembly techniques, block copolymer lithography or colloidal lithography can be used to create ordered patterns of micro- or nano-scale features on the surface (e.g., one or more of the first surface 302 and the second surface 304) of the discrete diamond layer 300-1. These techniques involve the self-assembly of polymer or colloidal particles, which function as a mask for subsequent etching of the diamond.

In an example implementation, the method 800 may include fabricating a thin resistive or capacitive touch sensor arrays directly on a surface (e.g., one or more of the first surface 302 and the second surface 304) of the discrete diamond layer 300-1, before attaching the discrete diamond layer 300-1 with the display module 404, 500, 600, 704. A size and shape of the discrete diamond layer 300-1 may be dependent on size and shape of the seed utilized for synthesis of the discrete diamond layer 300-1. Therefore, seeds of specific sizes and shapes may be utilized to obtain the discrete diamond layer 300-1 of various sizes and shapes.

In accordance with an implementation, the method 800 may further include the step of feedstock purification, where contaminants like nitrogen and metal particles from precursor gases (methane, hydrogen) are removed to prevent in-growth defects.

The method 800 of obtaining the discrete diamond layer 300-1 may further include one or more steps for introducing the flexibility in the discrete diamond layer 300-1. The flexibility may be achieved by modifying the chemical properties and/or microstructure of the discrete diamond layer 300-1. The flexibility of the discrete diamond layer 300-1 may be achieved by modifying the chemical properties and microstructure when the discrete diamond layer 300-1 is being formed during the step 804 of the method 800. Thereafter, the discrete diamond layer 300-1 obtained at step 806 may be exposed to post-growth surface treatments. The post-growth surface treatments of the discrete diamond layer 300-1 may include plasma etching, ion implantation, or laser irradiation. The post-growth surface treatments modify the surface chemistry of the discrete diamond layer 300-1 and may create defects or stress-relieving structures. For example, the process of plasma etching selectively removes sp3-bonded carbon atoms from the first surface 302 and the second surface 304 of the discrete diamond layer 300-1 and creates a thin layer of sp2-bonded carbon that enhances surface flexibility.

At step 804, when the seed is exposed to chemical vapors, a diamond layer grows on the seed with the CVD process. During the deposition, nanocrystalline diamond structures are formed over the seed by using a gas mixture of 2% methane (CH₄) in hydrogen (H₂). Further, the nanocrystalline diamond with grain sizes in the range of 10nm to 50 nm may formed by maintaining the pressure inside the CVD reactor at 100 Torr and a substrate temperature at 600°C, along with a plasma power density of 10 W/cubic centimeter (cm³). The nanocrystalline diamond layer, with grain sizes below 100 nm, exhibits increased flexibility compared to microcrystalline or single-crystal diamond due to the presence of grain boundaries and the reduced brittleness associated with smaller grain sizes.

Further, at step 804, the CVD process is tuned for formation of sp2-bonded carbon atoms at the grain boundaries of the nanocrystalline diamond. The presence of sp2-bonded carbon atoms, such as graphitic or amorphous carbon, at the grain boundaries enhance the flexibility of the discrete diamond layer 300-1by allowing greater inter-grain sliding and deformation without fracture. The tuning includes adjusting the CVD growth parameters, such as the gas composition, plasma power density, substrate temperature, and the introduction of at least one of nitrogen and oxygen in the gas composition.

For example, the CVD growth parameters may be adjusted by increasing the methane concentration in the gas composition, maintaining predefined the plasma power density and substrate temperature, and introducing predefined amounts of at least one of nitrogen and oxygen. The formation of sp2-bonded carbon at the grain boundaries is promoted. The adjusted CVD growth parameters create conditions that favor the retention of non-diamond carbon phases and disrupt the diamond lattice, and which leads to the incorporation of sp2-bonded carbon atoms at the grain boundaries of the nanocrystalline diamond.

In some embodiments, sp2-bonded carbon atoms may be formed at the grain boundaries of the nanocrystalline diamond by using a gas mixture of 8% methane (CH₄) in hydrogen (H₂), a plasma power density of 3 W/cm³, a substrate temperature of 500°C, and introducing 0.5% nitrogen (N₂) relative to hydrogen (H₂) can result in the formation of nanocrystalline diamond with a higher concentration of sp2-bonded carbon at the grain boundaries.

Further, the doping and impurity incorporation such as boron, nitrogen, or sulfur during the CVD process modifies the chemical bonding and electronic structure of the discrete diamond layer 300-1, which introduces elasticity. Furthermore, the textured surface 308 and specific orientations, such as (111) lattice or (110) lattice plane parallel to a surface of the seed, of the diamond grains in the discrete diamond layer 300-1 may lead to anisotropic mechanical properties which further enhances flexibility in specific directions.

The transparent protective cover 300 is scalable and may be manufactured in different sizes for application in different display devices or electronic apparatus. For example, an electronic apparatus may be a mobile phone, smartphone, tablet, laptop, digital book, personal digital assistant, digital camera, infotainment system for vehicles, wearable devices (like smart watches, smart glasses, AR headsets, VR headset), touchscreen medical/diagnostic devices, touchscreen control panels, gaming consoles, televisions, computer monitors, etc.

The discrete diamond layer 300-1 is a self-supporting structure that is distinct from the thin film diamond coatings commonly used in display devices. The monolithic nature of the discrete diamond layer 300-1 allows it to be fabricated separately and then integrated with the display module as a standalone component. The monolithic structure of the discrete diamond layer 300-1 provides numerous advantages over the thin film diamond coatings in terms of enhanced impact resistance, thermal management, and optical properties. For example, the discrete diamond layer 300-1 may have substantial thickness over the thin film diamond coatings which may result in enhanced impact resistance and protection against breakage. The discrete diamond layer 300-1 integrates as an individual component within the display stack and therefore, may be reused in the manufacturing of a new display devices. The discrete diamond layer 300-1 may exhibit flexibility while maintaining structural integrity when manufactured with nanocrystalline diamonds and sp-2 carbon atoms deposited at the grain boundaries. The discrete diamond layer 300-1 may have multiple sub-layers with varying properties and may be customized for desired performances. Further, the discrete diamond layer 300-1 may be subjected to various treatment(s) for formation of textured surfaces 308 that improves optical performance and reduced optical losses at diamond-air interface. Further, the lattice orientations, doping profile, and grainsize enhance optical properties such as brightness, contrast, and viewing angles when the discrete diamond layer 300-1 is stacked over the display module 404, 500, 600.

FIG. 9A is a perspective view of an electronic apparatus 900 having the transparent protective cover 300 integrated with a display device 902. The display device 902 is a touchscreen device with the transparent protective cover 300.

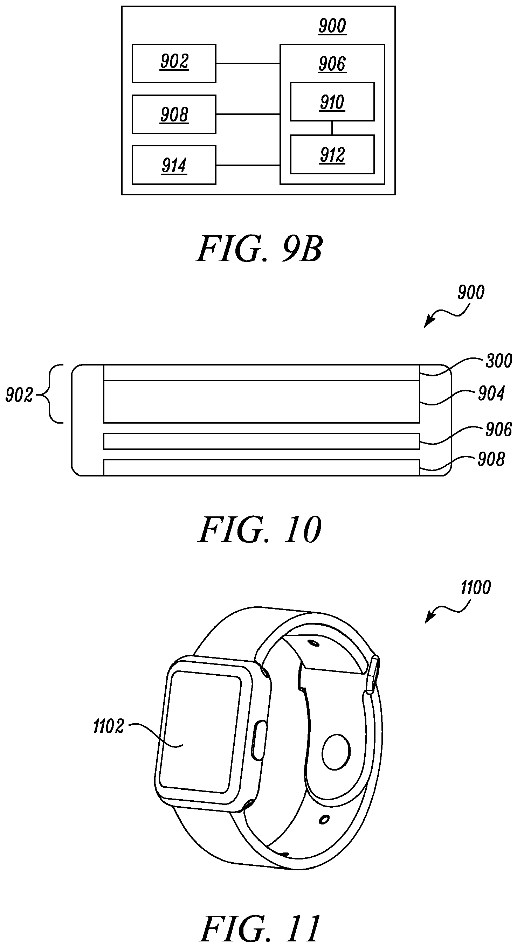

FIG. 9B is a schematic block diagram of the electronic apparatus 900. The electronic apparatus 900 may include the display device 902, a circuit board 906, a battery module 908 and input/output interfaces 914. The circuit board 906 includes one or more processor(s) 910 and a memory 912 and provides interfaces to interconnect the processor(s) 910, the memory 912, and the input/output interfaces 914. The processor(s) 910 and the display device 902 are coupled with each other through the circuit board 906. The battery module 908 may provide power to electrical components, including the one or more processor(s) 910, memory 912, and the display device 902 of the electronic apparatus 900.

FIG. 10 illustrates a cross-sectional view of the electronic apparatus 900 along a line 1-1 of FIG. 9A. As shown in FIG. 10, the electronic apparatus 900 includes the display device 902. The display device 902 has the transparent protective cover 300 attached to a display module 904. The display module 904 may be the display module 404, 500 or 600 or may be a combination of the touch detection module 702 and the display module 704. The transparent protective cover 300 may seal the display module 904 from exposure to the external environment and provides a reinforced structure to the display device 902 along with improved optical characteristics. Further, the electronic apparatus 900 is configured to include the circuit board 906 and the battery module 908.

The circuit board 906 may include at least one processor 910, a memory 912, and one or more input/output interfaces (not shown). The circuit board 906 is coupled to the display device 902 through a flexible printed circuit board (FPCB). The processor 910 sends signals to the display module 904 of the display device 902 through circuit board 906. Further, the processor 910 reads any touch related signals on the touch detection module 702 of the display device 902 through circuit board 906. The battery module 908 powers the electronic apparatus 900.

The processor(s) 910 may be implemented as microprocessors, microcomputers, microcontrollers, digital signal processors, central processing units, state machines, logic circuitries, and/or any devices that manipulate signals based on operational instructions. Among other capabilities, the processor 910 may fetch and execute computer-readable instructions stored in the memory 912 coupled to the processor 910 of the electronic apparatus 900. The memory 912 may include any non-transitory computer-readable storage medium including, for example, volatile memory (e.g., RAM), and/or non-volatile memory (e.g., EPROM, flash memory, NVRAM, memristor, etc.)

FIG. 11 is a perspective view of a wearable device 1100 (which may be a smartwatch) having the transparent protective cover 300 integrated with a display device 1102. The wearable device 1100 may have the display device 1102 as described in the above embodiments. The transparent protective cover 300 may be fabricated in accordance with a size and shape of the display device 1102.

The discrete diamond layer 300-1 may provide improved impact resistance as compared to glass based protective layers like Gorilla^{®} glass. For example, the discrete diamond layer 300-1, having a thickness within a range of 0.1 mm to 0.3 mm, may can provide up to ten times higher impact resistance over glass based protective layers.

With the discrete diamond layer 300-1 as a protective layer in the display device 400, 700, 902 of the present subject matter, the impact resistance of the display device has a significant improvement over a glass based protective or cover layer. Further, the discrete diamond layer 300-1 may provide the enhanced resistance at a thickness below the half of the thickness of a regular glass based protective layer. For example, a protective glass layer in a display device has a thickness in a range of 0.5 mm to 0.7 mm, whereas the discrete diamond layer 300-1 of the present subject matter may provide enhanced impact resistance and optical efficiency at a lesser thickness of 0.2 mm. As a result, the overall thickness and weight of the display device 400, 700, 902 is also reduced. In some embodiments, the discrete diamond layer 300-1 may reduce the overall thickness of the display device 400, 700, 902 up to twenty percent as compared to the display devices integrated with glass based protective layers.

Further, the protrusions 309 on at least one of the first surface 302 or the second surface 304 of the discrete diamond layer 300-1 functioning as micro lenses optimize brightness of the display device 400, 700, 902 and may further result in power savings of the associated electronic apparatus. The protrusions 309 may isolate and confine light emission zones and enables pixel density scaling. Also, the display devices 400, 700, 902 with the discrete diamond layer 300-1 may accommodate up to twenty percent (20%) more pixels per inch as compared to the baseline display devices.

Further, the discrete diamond layer 300-1 has relatively low reflectance (approximately 2.5%) as compared to the existing protective layers coated with anti-reflection element (approximately 8%). Thus, the discrete diamond layer 300-1 provides enhanced outdoor visibility. The reduction in reflections improve an on-off ratio between the pixels and which may result in increase in contrast ratio of up to 2.5 times as compared to the existing glass based protective layers.

The diamond based transparent protective cover 300 of the present subject matter completely replaces the protective layers made of glass/polypropylene or protective layers that are coated with a thin film of diamond. Thus, the discrete diamond layer 300-1 of the transparent protective cover 300 eliminates a glass-air interface and allows smaller pixel pitches without leakage and/or crosstalk.

Moreover, the presence of doping elements in the discrete diamond layer 300-1 improves the optical characteristics by expanding the color gamut up to eighteen percent (18%). The lattice arrangement of the diamond grains in the discrete diamond layer 300-1 improves optical transmission efficiency, which translates into brighter images at relatively lower power and makes the display devices 400, 700, 902 energy efficient. Additionally, optimized photon transport enhances overall visual quality.

Furthermore, a diamond has innate qualities like antimicrobial properties, efficient in thermal diffusion, and sensitivity to electrical inputs. The antimicrobial properties improve hygiene quality of the touch screen device 700. The discrete diamond layer 300-1 may be integrated with touch sensors, which ensures that a touch interface of the touch screen device 700 is sensitive and accurate to receive a user input.

The utilization of the discrete diamond layer 300-1 provides a thinner display stack and may reduce the overall thickness of an electronic apparatus. For example, a smartphone (not shown) with a glass based protective layer (thickness in the range of 0.5 mm to 0.7 mm) may have a total thickness of approximately 3.1 mm. Further, the smartphone may have the glass based protective layer with the thin film of diamond coatings, which may result into a total thickness of around 3.2 mm. Whereas, a smartphone integrated with the discrete diamond layer 300-1, in accordance with the embodiments of the present disclosure, may have a reduced total thickness of approximately 2.6 mm. Further, the discrete diamond layer 300-1 is lighter than glass based protective layers and may reduce the overall weight of the smartphone.

The one or more embodiments of the transparent protective cover 300 and the method to obtain the same, as described above, are eco-friendly as the discrete diamond layer 300-1 is obtained without requiring deep excavations or mining. Further, the characteristics of the discrete diamond layer 300-1, as described above, makes them reusable. The discrete diamond layer 300-1 may have life beyond the components of the electronic apparatus (wearable device) 900, 1100. Therefore, the discrete diamond layer 300-1 may be separated from the defective / malfunctioning / non-working display devices and may be reused in manufacturing new display devices. Further, unlike glass based protective layer, the electronics apparatus with the discrete diamond layer 300-1 may not need additional external protective layers, such as screen guards. An external protective layer may increase thickness and weight of the electronic apparatus. A glass based protective layer may have hardness value in the range of 5 to 6 on Moh's scale, whereas the diamond-based protective layers may have the hardness value of 10 Moh's scale. As a result, the electronic apparatus (wearable device) 900, 1100 with the discrete diamond layer 300-1 integrated display device 400, 700, 902 may remain in an original configuration along with reduced thickness and weight.

It will be apparent to those skilled in the art that various modifications and variations can be made to the method and/or system of the present disclosure without departing from the scope of the disclosure. Other embodiments will be apparent to those skilled in the art from consideration of the specification and practice of the method and/or system disclosed herein. It is intended that the specification and examples be considered as exemplary only, with a true scope of the disclosure being indicated by the following claims and their equivalent.

## Claims

1. A transparent protective cover (300) for a display device (400, 700, 902), the transparent protective cover (300) comprising:
a discrete diamond layer (300-1) including a first surface (302) and a second surface (304), wherein the second surface (304) is configured to adhere to a display module (404, 500, 600) of the display device (400, 700, 902) and the first surface (302) is configured to face away from the display module (404, 500, 600) and wherein:
at least one of the first surface (302) and the second surface (304) has a textured surface (308) configured to direct light away from the display module (404, 500, 600, 704) in a predetermined direction; and
the discrete diamond layer (300-1) has a diamond grain size below 500 nano meters (nm), and dopants in a range of 10¹³ atoms/cubic centimeter to 10¹⁸ atoms/cubic centimeter.

2. The transparent protective cover (300) of claim 1, wherein the textured surface (308) includes plurality of protrusions (309) to prevent internal reflection of the light back towards the display module (404, 500, 600, 704).

3. The transparent protective cover (300) of claim 2, wherein the plurality of protrusions (309) are multi-faced structures and define at least one of a pyramidal structure (310), conical structure (314), moth-eye structure (312) or lens-shaped structure (316).

4. The transparent protective cover (300) of claim 1, wherein a thickness of the discrete diamond layer (300-1) is in a range of 0.1 milli meter to 0.3 milli meter.

5. The transparent protective cover (300) of claim 1, wherein a thickness of the discrete diamond layer (300-1) is 0.2 milli meter.

6. The transparent protective cover (300) of claim 1, wherein the discrete diamond layer (300-1) has nanocrystalline diamonds with grain size below 100 nano meters, and wherein grain boundaries of the nanocrystalline diamonds have sp2-bonded carbon atoms.

7. The transparent protective cover (300) of claim 1, wherein a majority of diamond grains in the discrete diamond layer (300-1) have size in a range of 200 nano meters to 300 nano meters.

8. The transparent protective cover (300) of claim 1, wherein the discrete diamond layer (300-1) is doped with one of a p-type boron and n-type phosphorus.

9. The transparent protective cover (300) of claim 1, wherein the discrete diamond layer (300-1) is doped with boron and nitrogen.

10. The transparent protective cover (300) of claim 1, wherein the discrete diamond layer (300-1) includes a plurality of sub-layers (306-1, 306-2, 306-3), and wherein:
a doping concentration in each sub-layer of the plurality of sub-layers (306-1, 306-2, 306-3) is different from a doping concentration in an adjacent sub-layer of the plurality of sub-layers (306-1, 306-2, 306-3) adjoining each sub-layer,
a doping element in each of the plurality of sub-layers (306-1, 306-2, 306-3) is different from a doping element in the adjacent sub-layer,
at least one layer of the plurality of sub-layers is undoped, and
a diamond grain size in each sub-layer of the plurality of sub-layers (306-1, 306-2, 306-3) is different from a diamond grain size in the adjacent sub-layer.

11. The transparent protective cover (300) of claim 1, wherein the discrete diamond layer (300-1) has crystal orientation of one of [111] lattice and [110] lattice.

12. The transparent protective cover (300) of claim 1, wherein the discrete diamond layer (300-1) is a monolithic structure produced by a chemical vapor deposition (CVD) process.

13. A display device (400, 700, 902), comprising:
a display module (404, 500, 600, 704), wherein the display module (404, 500, 600, 704) is one of a liquid crystal display (LCD) (500), an organic light emitting diode (OLED) display (600), an active-matrix OLED (AMOLED) display, and a quantum dot LED (QLED) display; and
a transparent protective cover (300), wherein the transparent protective cover (300) includes:
a discrete diamond layer (300-1) comprising a first surface (302) and a second surface (304), wherein the second surface (304) is configured to adhere to the display module (404, 500, 600) and the first surface (302) is configured to face away from the display module (404, 500, 600, 704) and wherein:
at least one of the first surface (302) and the second surface (304) has a textured surface (308) configured to direct light away from the display module (404, 500, 600, 704) in a predetermined direction;
the discrete diamond layer (300-1) has diamond grain size below 500 nano meters and dopants in a range of 10¹³ atoms/cubic centimeter to 10¹⁸ atoms/cubic centimeter.

14. The display device (400, 700, 902) of claim 13, wherein the discrete diamond layer (300-1) has crystal orientation of one of [111] lattice and [110] lattice.

15. The display device (400, 700, 902) of claim 13, wherein the display device (400, 700, 902) includes a touch detection module to detect touch inputs received on the first surface (302) of the discrete diamond layer (300-1).

16. The display device (400, 700, 902) of claim 15, the touch detection module has touch detection sensors provided at the second surface (304) of the discrete diamond layer (300-1).

17. An electronic apparatus (900, 1100), comprising:
the display device (400, 700, 902) of claims 13 to 16; and
a circuit board (906) including at least one processor (910) and a memory (912), wherein the at least one processor (910) is coupled to the display module (404, 500, 600, 704) through the circuit board (906).

18. A method for obtaining a transparent protective cover (300) for a display device (400, 700, 902) through chemical vapor deposition (CVD), the method comprising:
providing a seed inside a CVD reactor, wherein the seed is one of a silicon or a glass;
exposing the seed to chemical vapors for formation of a discrete diamond layer (300-1) on the seed, wherein:
a temperature and a pressure inside the CVD reactor are maintained at predetermined values,
the chemical vapors are doped such that the discrete diamond layer (300-1) has dopants in a range of 10¹³ atoms/cubic centimeter to 10¹⁸ atoms/cubic centimeter, and
a diamond grain size in the discrete diamond layer (300-1) is below 500 nano meters;
debonding the discrete diamond layer (300-1) from the seed, wherein the discrete diamond layer (300-1) has a first surface (302) and a second surface (304), and wherein the second surface (304) is configured to adhere to a display module (404, 500, 600) of the display device (400, 700, 902) and the first surface (302) is configured to face away from the display module (404, 500, 600, 704); and
forming a textured surface (308) on at least one of the first surface (302) and the second surface (304) of the discrete diamond layer (300-1), wherein the textured surface (308) is configured to direct light away from the display module (404, 500, 600, 704) in a predetermined direction.

19. The method of claim 18, wherein the exposing the seed to the chemical vapors for formation of the discrete diamond layer (300-1) comprises:
forming a plurality of sub-layers (306-1, 306-2, 306-3) by:
exposing the seed to a first type of chemical vapors for a first predetermined time period for formation of a first sub-layer (306-1) over the seed; and
exposing the seed to a second type of chemical vapors for a second predetermined time period for formation of a second sub-layer (306-2) over the first sub-layer (306-1), wherein the first type of chemical vapors has at least one of diamond grain size, dopant element, and doping concentration different from the second type of chemical vapors.

20. The method of claim 18, wherein the discrete diamond layer (300-1) is doped with one of p-type boron and n-type phosphorus.

21. The method of claim 18, wherein the discrete diamond layer (300-1) is doped with boron and nitrogen.

22. The method of claim 18, wherein forming the textured surface (308) on at least one of the first surface (302) and the second surface (304) of the discrete diamond layer (300-1) includes:
forming a plurality of protrusions (309) on at least one of the first surface (302) and the second surface (304) of the discrete diamond layer (300-1), and wherein the plurality of protrusions (309) is formed by one of photolithography and etching process, nanoimprint lithography, block copolymer lithography, and colloidal lithography.
